(19) Europäisches Patentamt
European Patent Office
Office européen des brevets

(11) **EP 2 629 041 B1**

(12) **EUROPÄISCHE PATENTSCHRIFT**

(45) Veröffentlichungstag und Bekanntmachung des Hinweises auf die Patenterteilung:
**30.08.2017   Patentblatt 2017/35**

(51) Int Cl.:
*F28F 3/12* (2006.01)          *H01L 23/473* (2006.01)

(21) Anmeldenummer: **13401013.1**

(22) Anmeldetag: **11.02.2013**

(54) **Wärmetauscherstruktur**

Structure of a heat exchanger

Structure d'échangeur de chaleur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.02.2012   DE 102012101186**

(43) Veröffentlichungstag der Anmeldung:
**21.08.2013   Patentblatt 2013/34**

(73) Patentinhaber: **Karlsruher Institut für Technologie 76131 Karlsruhe (DE)**

(72) Erfinder:
• **Weddigen, Andreas
  76139 Karlsruhe (DE)**
• **Wibel, Wolf
  76297 Blankenloch (DE)**

(56) Entgegenhaltungen:
DE-A1-102008 006 513     US-A- 4 712 158
US-B1- 7 992 625

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Wärmetauscherstruktur für eine Verdampferstruktur oder eine Verflüssigerstruktur, vorzugsweise als Komponente eines mikrostrukturierten Wärmeübertrager gemäß des ersten Patentanspruchs.

Die genannte Wärmetauscherstruktur dient der Fluiddurchführung einer Fluidfraktion oder eines Teils derselben durch einen Wärmetauscher, vorzugsweise einen fluidischen Mikrowärmetauschers in Schichtbauweise. In dem genannten Wärmetauscher erfolgt die Fluiddurchführung für die Fluidfraktionen jeweils ebenenweise in Mikrokanälen, wobei mit den jeweils anderen Fluidfraktionen durch Wärmeaustausch in Wechselwirkung stehen, d.h. sich erwärmen oder abkühlen.

Eine Verdampferstruktur ist eine Wärmetauscherstruktur, in der flüssige Bestandteile eines hindurchgeleiteten Fluids ganz oder teilweise verdampft werden. Das Fluid wird dabei vorzugsweise erwärmt.

Eine Verdampferstruktur wird z.B. in der Kältetechnik eingesetzt, z.B. als Oberflächenkühler bei Elektronikanwendungen (z.B. Chipkühlung), als Kühlpassage für Mikrowärmeübertrager (z.B. im Kühlschrank) oder für verfahrenstechnische Anwendungen, die möglichst vollständige Verdampfung erfordern. Als Medien dienen z.B. spezielle Kältefluide wie z.B. R134a für Kühlanlagen.

Bekannte mikrostrukturierte Verdampfungsstrukturen, wie beispielhaft in **[1]** oder **[2]** genannt, weisen bevorzugt lange gerade Kanälen auf. Es gibt zudem aber auch für Flüssigkeitsverdampfung entwickelte Mikrostrukturen wie den Rondenverdampfer, beispielhaft offenbart in **[3],** wobei während der Verdampfung die Durchmischung von flüssigen und dampfförmigen Fluid und damit die Temperaturverteilung verbessert wird.

Mikrostrukturierte Verdampferstrukturen sind in ihrer Effizienz eingeschränkt, da mit zunehmendem Dampfanteil des verdampfenden Fluids innerhalb des Verdampferstruktur die Restverdampfung des Dampf-Flüssigkeitsgemisch durch den zunehmenden Dampfanteil aus folgenden Gründen erschwert wird:

-   der Anteil des noch verdampfbaren Kühlmediums nimmt kontinuierlich ab. Aufgrund der extremen Volumenzunahme beim Phasenübergang sinkt der volumenbezogene Anteil noch verdampfbaren flüssigen Kühlmediums besonders stark.

-   die Wärmeleitfähigkeit der Dampfphase, die sich bevorzugt an den Wandungen der Mikrokanäle bildet, ist signifikant schlechter als die der flüssigen Phase. Dampf wirkt damit als Wärmedämmung und behindert eine weitere Verdampfung.

-   Aufgrund der starken Volumenzunahme des Dampfes bei gleichzeitig konstant geringem inneren Volumen eines mikrostrukturierten Verdampfers kommt es bei einer Verdampfung zu einem starken Anstieg der Fließgeschwindigkeit im verdampfenden Fluidgemisch. Dies reduziert die Verweilzeit des noch flüssigen Mediums in der Verdampferstruktur und damit die Verdampfungseffizienz signifikant.

-   mit Ansteigen der Fließgeschwindigkeit steigen auch die reibungsbedingten Druckverluste in den Mikrostrukturen, was sich auf die druckabhängige Verdampfungsenthalpie/ Verdampfungstemperatur auswirkt.

Die extreme Volumenzunahme bei Verdampfung ist insbesondere für Mikrostrukturen aufgrund derer kleinen inneren Volumen ein entscheidender Nachteil beim Betrieb von Verdampfungsstrukturen. Eine etwa 1000fache Volumenzunahme bei einer Verdampfung relativiert zahlreiche Vorteile von Mikrowärmetauscherstrukturen wie z.B. die hohe Leistungsübertragungsdichte aufgrund der großen spezifischen Verdampferflächen und der kurzen Wärmeübertagungswege oder auch die kompakte Bauform, die mikrofluidische Strukturen für den Wärmetransport für einphasige Flüssigkeiten auszeichnen. Die aufgrund des erhöhten Volumenflusses etwa 1000fach kürzere Verweilzeit des Mediums im Bauteil reduziert die übertragbare (und zur Verdampfung erforderliche) Wärmemenge. Die Volumenzunahme limitiert dadurch die bisherigen Mikroverdampfer.

Um eine möglichst vollständige Verdampfung des Fluids in der Verdampferstruktur zu ermöglichen, sind daher bisher entweder besonders große und damit mit größeren Herstellungskosten verbundene Verdampfungsstrukturen erforderlich oder stark reduzierte Volumenflüsse des zu verdampfenden (Kühl-) Mediums bei gleichzeitig verringerter Kühlleistung.

Eine Verflüssigerstruktur ist eine Wärmetauscherstruktur, in der gas- oder dampfförmige Bestandteile eines hindurchgeleiteten Fluids ganz oder teilweise kondensiert, d.h. verflüssigt werden. Das Fluid wird dabei vorzugsweise abgekühlt.

Auch für eine Verflüssigerstruktur behindern ein zunehmendes Zweiphasengemisch eine effiziente Kondensation in den Mikrokanälen. Die Wärmeübertragung erfolgt auch hier bevorzugt über die Wandungen der Mikrokanäle. Um eine möglichst vollständige Kondensation des Dampfes in der Verflüssigerstruktur zu ermöglichen, sind auch hier bisher entweder besonders große und damit mit größeren Herstellungskosten verbundene Verflüssigerstrukturen erforderlich oder stark reduzierte Volumenflüsse des Kühlmediums bei gleichzeitig verringerter Kondensationsleistung.

Aus **[4]** ist ferner ein Wärmetauscher mit einer verzweigten Leitungsstruktur für ein Wärmeträgerfluid für eine Temperierung eines Fluidstroms bekannt, umfassend mindestens einen Mikrokanal mit mindestens einer bogenförmiger Fluidführung nach zumindest einem Teil der Wärmetauschstrecke mit mindestens einer fluidischen Abzweigung für eine phasenreine Abzweigung einer durch die Temperierung in der Wärmetauschstrecke umgewandelten Phase des Fluidstroms an und/oder hinter der bogenförmigen Fluidführung, wobei alle der mindestens einen Abzweigung in mindestens einen Austrittskanal aus der Wärmetauscherstruktur ausmündet.

Davon ausgehend liegt die **Aufgabe der Erfindung** darin, eine Wärmetauscherstruktur der eingangs genannten Art jedoch mit erhöhter Effizienz vorzuschlagen.

Eine weitere Aufgabe der Erfindung liegt darin eine Verflüssigerstruktur und eine Verdampferstruktur mit erhöhter Effizienz vorzuschlagen.

Die Aufgabe wird durch einer Wärmetauscherstruktur mit den Merkmalen des Anspruchs 1, einer Verflüssigungsstruktur mit den Merkmalen des Anspruchs 3 sowie einer Verdampfungsstruktur mit den Merkmalen des Anspruchs 5 gelöst. Die auf diese rückbezogenen Unteransprüche geben vorteilhafte Ausgestaltungen wieder.

Ausgangspunkt ist ein Wärmetauscher mit Wärmetauscherstruktur sowie ein Verfahren zum Betreiben dieser Wärmetauscherstruktur. In dieser sind Kanäle als Passagen für einen Fluidstrom vorgesehen. Das Fluid wird beim Durchtritt durch diese Kanäle temperiert und durchläuft dabei vollständig oder teilweise eine Phasengrenze von flüssig zu gas- bzw. dampfförmig oder umgekehrt.

Eine Grundidee besteht darin, an mindestens einer Stelle je Kanal im Wärmetauscher den Fluidanteil aus dem Fluidstrom abzuzweigen, der durch die Temperierung die vorgenannte Phasenumwandlung bereits vollzogen hat. Der abgezweigte Teil des Fluidstroms wird durch ein entsprechendes Verfahren separat vorzugsweise auf direktem Weg aus der Wärmetauscherstruktur geleitet, während der restliche Teil des Fluidstroms in den Kanälen verbleibt und weiter temperiert wird. Folglich weist die Wärmetauscherstruktur Mittel zur Abzweigung des Teils des Fluidstroms auf, der durch die Temperierung die eine Phasenumwandlung bereits vollzogen hat (Zielphase).

Die Wärmetauscherstruktur wird je nach Auslegung für eine Verflüssigung oder Verdampfung eines dampfförmigen bzw. flüssigen Ausgangsfluides oder Fluidgemisches verwendet.

Eine weitere Verwendung zur Trennung eines Fluidgemisches aus zwei nicht miteinander lösbaren, aber in gleichem Aggregatzustand vorliegenden Fluiden ist mit der Wärmetauscherstruktur auch ohne einem Wärmeaustausch realisierbar. Sie ist aber durch die Erfindung mit abgedeckt.

Eine Durchmischung der flüssigen und gasförmigen Phasen in den Mikrokanälen würde zwar einen Wärmeaustausch durch Wärmeanbindung der Phasen an die Wandungen als Wärmeaustauschflächen begünstigen und damit die Effizienz der Wärmeübertragung steigern, stört aber eine phasenreine Abtrennung der bereits umgewandelten Phase. Es wird folglich vorzugsweise eine Vermeidung einer Vermischung angestrebt. Ein Ziel liegt darin, die Zielphasen, d.h. die Fluidanteile, die bereits eine Phasenänderung durchlaufen sind, von dem weiteren Wärmeaustausch fernzuhalten und die Wärmeaustauschflächen möglichst ausschließlich für die Phasenumwandlung der noch umzuwandelnden Phasen zur Verfügung zu stellen.

Die Lösung der Aufgabe basiert folglich auf einer Modifikation der eingangs beschriebenen Wärmetauscherstruktur mit den vorgenannten Mitteln dahingehend, dass in den Mikrokanälen an mindestens einer Stelle pro Mikrokanal eine Abzweigung der vorgenannten Zielphasen in einen separaten Abzweigungskanal erfolgt. Die Abzweigungskanäle dienen der direkten Ausleitungen der Zielphasen aus den Wärmetauscher, während die noch nicht phasenumgewandelten Anteile des Fluidstroms in den Mikrokanälen im Wärmetauscher verbleiben. Die noch umzuwandelnden Fluidphasen, d.h. bei einer Verdampferstruktur die flüssigen und bei einer Verflüssigerstruktur die gasförmigen Fluidbestandteile verbleiben dann vorzugsweise ausschließlich, d.h. ohne die bereits umgewandelten Anteile in den Mikrokanälen und damit im Einflussbereich der Wärmeübertragung. Die abgezweigten Phasenbestandteile beeinflussen insbesondere nicht mehr in eingangs genannter Weise die Wärmeübertragung und die Verweilzeiten der nicht umgewandelten Fluidphasen in den Mikrokanälen.

Vorzugsweise sind die Abzweigungen über die gesamte Kanallängen verteilt (bevorzugt in gleichen Abständen zueinander) angeordnet, sodass an mehreren Stellen eine stoffliche Abtrennung erfolgt und eine Phasenhomogenität in den gesamten Kanallängen angestrebt wird. Die Abtrennung erfolgt dabei laufend. Die jeweils schon umgewandelten Fluidphasen werden als Zielphasen, d.h. bei einer Verdampferstruktur die gasförmigen und bei einer Verflüssigerstruktur die flüssigen Fluidbestandteile vorzugsweise bereits kurz nach der Entstehung und nicht nach einem vollständigen Durchlauf durch die Abzweigungen aus dem Fluidstrom entfernt. Weiter bevorzugt ist die Abtrennung kontinuierlich oder quasikontinuierlich, d.h. sie erfolgt an einer Vielzahl von hintereinander an den Mikrokanälen angeordneten Abzweigungen.

In der Wärmetauscherstruktur entsteht bei Temperierung ein zweiphasiger Fluidstrom, der durch die genannten Mittel in einen gas- bzw. dampfförmigen und einen flüssigen Phasenteilstrom aufgeteilt wird. Die Aufteilung der Phasen erfolgt vorzugsweise über eine Durchleitung des Fluidstroms durch bogenförmige Kanalkrümmungen (bogenförmige Fluidführung). Die stoffliche Phasentrennung von dampf- bzw. gasförmiger zu flüssiger Phase erfolgt in der Strömungsumlenkung aufgrund der in der bogenförmigen Fluidführung unterschiedlich hoch auf die leichteren gas- oder dampfförmigen und die schwereren flüssigen Phasen einwirkenden Zentrifugalkräfte. Entsprechend der gewünschten Zielphase werden die Ableitungen in oder bevorzugt unmittelbar nach einer bogenförmigen Kanalkrümmung an der Innenseite, d.h. an der innen liegenden Wandung der Kanalkrümmung oder an der Außenseite, d.h. an der außen liegenden Wandung der Kanalkrümmung angeordnet.

In einer bevorzugten Ausführung zweigen die Ableitungen tangential in Strömungsrichtung aus den Mikrokanälen aus. Damit werden mögliche Staudrücke reduziert.

Bei einer Verdampferstruktur wird der dampfförmige, d.h. der nach Phasenübergang gasförmige Anteil des Fluids über mindestens eine fluidische Abzweigung vorzugsweise an der Innenseite, d.h. an der innen liegenden Wandung der Kanalkrümmung an oder hinter der bogenförmigen Fluidführung vorzeitig aus den Mikrokanälen der Mikrostruktur abgezweigt. Der abgezweigte Anteil kann dann optional z.B. in Sammelkanälen (z.B. Austrittskanalstrang) zusammengeführt und in diesen oder in einzelnen Austrittskanälen auch weiter überhitzt werden (z.B. Nassdampf zu Trockendampf). Die Sammelkanäle bzw. Austtrittskanalstränge dienen als Überhitzer. Der in den Mikrokanälen verbleibende flüssige Fluidanteil erfährt eine erhöhte Verweilzeit innerhalb der Mikrostruktur. Dies ermöglicht eine verbesserte Verdampfung aus folgenden Gründen:

- der Anteil noch verdampfbaren Mediums in den Mikrokanälen bleibt hoch, der Wärmeaustausch konzentriert sich auf den Fluidstromanteil, der den Phasenübergang noch nicht überwunden hat.

- die Verweilzeit des noch nicht verdampften Fluids in den Mikrokanälen erhöht sich, da durch eine laufende Abtrennung der sich bildenden Zielphasen einer signifikanten Volumenflusszunahme durch Verdampfung entgegengewirkt wird.

- es ergeben sich zusätzliche Verbesserungen des Wärmetransports der zur Verdampfung erforderlichen Wärmemenge, da die Wärmeleitfähigkeit des flüssigen Mediums signifikant über der des verdampften Mediums liegt und diese wärmedämmende Wirkung des Dampfes insbesondere in wandungsnahen Bereichen, in denen die bevorzugte Dampfbildung einsetzt, entfällt oder reduziert wird.

Bei einer Verflüssigungsstruktur erfolgt innerhalb der Mikrostruktur ebenfalls eine Trennung flüssiger und gasförmiger Fluidphasen über die in Kanalkrümmungen (bogenförmige Fluidführung) hervorgerufenen Zentrifugalkräfte. Vorzugsweise wird der kondensiertes, d.h. der nach Phasenübergang flüssige Anteil des Fluids über mindestens eine fluidischen Abzweigung vorzugsweise an der Außenseite, d.h. an der außen liegenden Wandung der Kanalkrümmung an oder hinter der bogenförmigen Fluidführung vorzeitig aus den Mikrokanälen der Mikrostruktur abgezweigt. Der in den Mikrokanälen verbleibende dampfförmige Fluidanteil hingegen erfährt eine erhöhte Verweilzeit innerhalb der Mikrostruktur. Der reduzierte Anteil an kondensierten und flüssigen Bestandteilen wird vorzugsweise durch die Ableitungen bevorzugt in regelmäßigen Abständen zueinander abgeführt, sodass eine Belegung insbesondere der als Kondensationsflächen dienenden Wandungen der Mikrokanäle mit kondensierten Fluidanteilen reduziert wird. Der Wärmeaustausch findet mangels flüssiger Anteile insbesondere in vorteilhafter Weise direkt an den Wandungen, d.h. im wandnahen Bereichen mit den dampfförmigen Fluidanteilen in den Mikrokanälen statt, was zusammen mit der erhöhten Verweilzeit eine Effizienzverbesserung der Verflüssigungsstruktur bewirkt.

Die auf ein in einer bogenförmigen Strömungsführung fließendes Fluid wirkende Zentrifugalkraft $F_z$ berechnet sich aus

$$ F_z = m \cdot v^2/r $$

(m = Fluidmasse, v = Strömungsgeschwindigkeit, r = Strömungsradius).

Fließt das Medium in einem Mikrokanal in einer gekrümmten Fluidführung, werden die Bereiche flüssigen (schwer) und verdampften Mediums (leicht) voneinander aufgrund der um etwa den Faktor 1000 unterschiedlichen Dichten (z.B. für Wasser) und damit unterschiedlichen Massen m gravimetrisch getrennt. Aufgrund der kleinen Kanalquerschnitte für Mikrostrukturen ergeben sich gegenüber größeren Kanalquerschnitten bei gleichem Volumenfluss viel höhere Strömungsgeschwindigkeiten v. Bei einer Verdampfung kommt es aufgrund der starken Volumenzunahme zu einem weiteren Anstieg der Geschwindigkeit v. Zudem können mit Mikrostrukturen Kanalführungen mit besonders kleinen Radien r realisiert werden. Hierdurch ergeben sich extrem viel größere Werte für die Zentrifugalkraft $F_z$, als es in konventionellen makroskopischen Verdampfer /Verflüssiger möglich wäre. Die Nutzung der Zentrifugalkraft für diese besonders effektive Phasentrennung wird daher erst durch Einsatz von Mikrostrukturtechnik möglich. In einem Mikroverdampfer oder Verflüssiger mit gekrümmten Mikrokanälen wird daher die dichtere flüssige Phase an die Außenkrümmung des Mikrokanals transportiert, während die weniger dichte Dampfphase an die Innenseite transportiert wird.

Die Erfindung wird im Folgenden anhand von Ausführungsbeispielen erläutert, die optional auch mit einzelnen oder allen vorgenannten Maßnahmen zusätzlich kombinierbar oder erweiterbar sind. Es zeigen

**Fig.1a bis g** schematische Draufsichten von einfachen nicht nach der Erfindung Beispiele einer Verdampferstruktur (**a bis d**) und einer Verflüssigungsstruktur (**e bis h**) mit nur einem Mikrokanal,

**Fig.2a und b** schematische Draufsichten von zwei beispielhaften Ausführungen einer Verdampfungsstruktur,

**Fig.3** die schematische Draufsicht einer beispielhaften Ausführung einer Verflüssigungsstruktur sowie

**Fig.4** eine Draufsicht einer beispielhaften Folie mit Mikroverdampfer.

Alle in den **Figuren** dargestellten Ausführungsformen zeigen Designvorschläge für ein Kanallayout für flächige Wärmetauscherstrukturen. Die Fließrichtung **1** für den Fluidstrom ist von oben nach unten. Die dargestellten Strukturen sind ebene Kanalstrukturen, werden vorzugsweise in Platten oder Folien eingearbeitet und in einem Mikrowärmetauscher aus gestapelten Platten oder Folien der bekannten Grundbauform integriert.

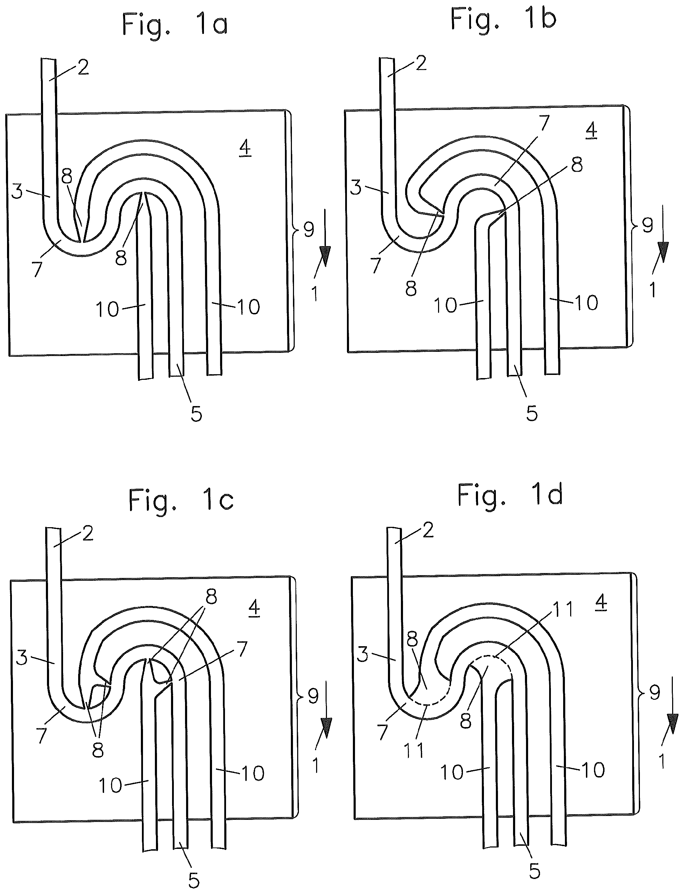

**Fig.1a bis g** zeigen einfache Beispiele der Wärmetauscherstrukturen beispielhaft auf einer Platten- oder Folienebene **4** mit einem durchgehenden Mikrokanal **3** mit Zulauf **2** und Austritt **5** insbesondere für nicht umgewandelte Fluidanteile. Die Ausdehnung der Folienebene **4** begrenzt grundsätzlich die Wärmeübertragungstrecke **9** des Mikrokanals **3**. Vorzugsweise erstreckt sich die Wärmeübertragungsstrecke bis zur in Fließrichtung gesehen letzten Abzweigung des Mikrokanals. Alle Ausführungen zeigen ferner zwei bogenförmige Fluidführungen **7** mit je einer fluidischen Abzweigung **8** zu einem Austrittskanal **10** für umgewandelte, d.h. verdampfte oder verflüssigte Fluidanteile. **Fig.1a bis d** zeigen Verdampferstrukturen als Wärmetauscherstruktur, die sich dadurch auszeichnen, dass die Abzweigung **8** an der Innenseite der bogenförmigen Fluidführung **7** angeordnet ist und zwar je nach Verdampfungs- und Fließkinematik an **(Fig.1a)** oder hinter der bogenförmigen Fluidführung **(Fig.1b)**. Ist ein Durchfluss durch die gesamte bogenförmige Fluidführung für eine gravimetrische Trennung der flüssigen und gasförmigen Fluidanteile erforderlich, erfolgt die Abzweigung nach der gesamten bogenförmigen Fluidführung **(Fig.1a)**. Andererseits begünstigt eine Überleitung von einer bogenförmigen Fluidführung in eine unmittelbar nachfolgende gegenläufig orientierte bogenförmige Fluidführung ohne Abzweigung eine stoffliche Trennung im darauf folgenden Fluidführungsabschnitt (vgl. **Fig.1b**). Bevorzugt bei einer starken Dampfbildung insbesondere innerhalb einer bogenförmigen Fluidführung sind auch mehrere Abzweigungen an einer bogenförmigen Fluidführung vorteilhaft **(Fig.1c)** oder die Abzweigung erstreckt sich kontinuierlich über ein Bogensegment, wobei die bogenförmigen Fluidführung innenseitig vorzugsweise durch eine gasdurchlässige Membran **11**, alternativ einen gasdurchlässigen vorzugsweise offenporigen Körper wie z.B. ein Filterelement begrenzt ist **(Fig.1d)**. Die Abzweigungen sind vorzugsweise als Wandungsöffnungen für eine bevorzugte Unterdruckabsaugung über die Austrittskanäle konzipiert. Vorzugsweise münden die Wandungsöffnungen tangential in Durchflussrichtung aus den Fluidführungen aus. Als Leitungen für kompressible Medien wie Dämpfe oder Gase weisen die Austrittskanäle **10** dabei bevorzugt einen größeren Durchflussquerschnitt als der Mikrokanal **3,** in dem überwiegend inkompressible Fluidanteile fließen, auf. Die Austrittskanäle sind optional als Überhitzer einsetzbar, wobei von einer ausreichende Wärmedämmung allein durch das Platten- oder Folienmaterial (z.B. nicht rostender Chrom-Nickel-Stahl) auch ohne zusätzliche Wärmebarrieren (z.B. Kavitäten) ausgegangen wird.

Das entsprechende Verfahren zur Verdampfung kennzeichnet sich dadurch, dass in den Mikrokanal flüssige Fluide erhitzt und zumindest teilweise verdampft werden, wobei die verdampften, d.h. dampfförmigen Fluidanteile vorzugsweise unmittelbar nach deren Bildung über die Abzweigungen abgesaugt oder abgeleitet werden.

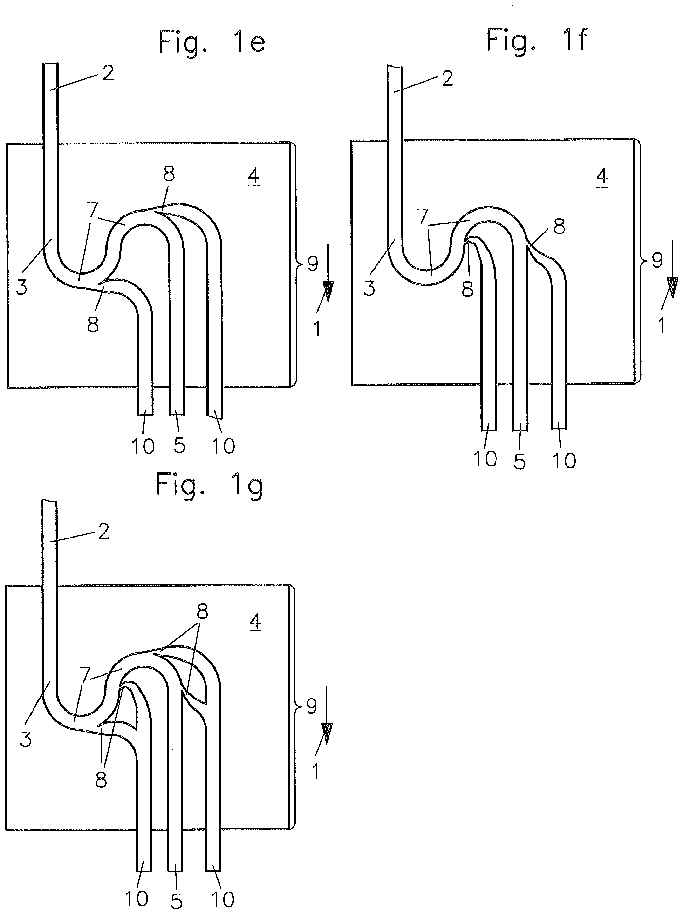

**Fig.1e bis g** zeigen dagegen Verflüssigungsstrukturen als Wärmetauscherstruktur, die sich dadurch auszeichnen, dass die Abzweigung **8** an der Außenseite der bogenförmigen Fluidführung **7** angeordnet ist und zwar je nach Kondensations- und Fließkinematik an **(Fig.1e)** oder hinter der bogenförmigen Fluidführung **(Fig.1f)**, bei kontinuierlicher Kondensation insbesondere im Bereich der bogenförmigen Fluidführung alternativ an mehreren Stellen **(Fig.1g)**. Die Abzweigungen sind als Wandungsöffnungen konzipiert, wobei diese vorzugsweise an den Wandungsöffnungen tangential in Durchflussrichtung aus den Fluidführungen ausmünden. Als Leitungen für flüssige inkompressible Medien weisen die Austrittskanäle **10** dabei bevorzugt einen geringeren Durchflussquerschnitt als der Mikrokanal **3,** in dem überwiegend die nicht oder noch nicht kondensierte und damit kompressible Fluidanteile fließen, auf. Die Austrittskanäle sind optional auch als Unterkühler zur Reduzierung eines ggf. mit abgezweigten Dampfanteils durch Nachkondensation einsetzbar, wobei von einer ausreichende Wärmedämmung allein durch das Platten- oder Folienmaterial (z.B. nicht rostender Chrom-Nickel-Stahl) auch ohne zusätzliche Wärmebarrieren (z.B. Kavitäten) ausgegangen wird.

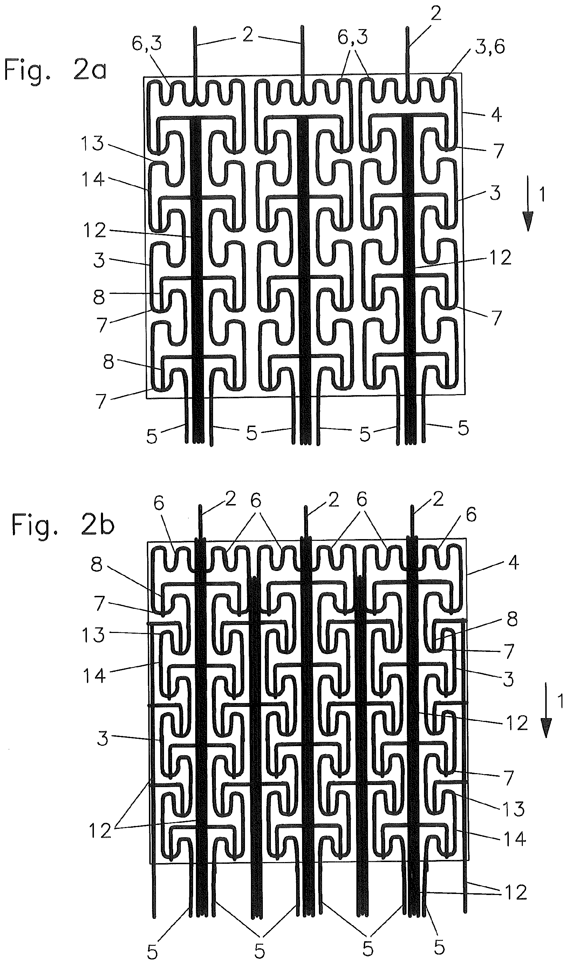

**Fig.2a und b** zeigen jeweils schematische Darstellungen einer beispielhaften Mikrokanalanordnung auf einer schematisch dargestellten Platten- oder Folienebene **4** eines nicht weiter dargestellten Mikrowärmetauschers in Schichtbauweise, mit der die Trennung von Flüssig- und Dampfphase für einen Mikroverdampfer realisiert wird. Sie umfassen Zuläufe **2** für ein zu verdampfenden Fluid, die in jeweils zwei Mikrokanäle **3** unterteilt werden. Die Mikrokanäle durchlaufen die gesamte Folienebene **4** bis zum Austritt **5** und umfassen neben einer Einlaufstrecke **6** mehrere bogenförmige Fluidführungen **7** mit je einer fluidischen Abzweigung **8** an der jeweiligen Innenseite eines Teils der bogenförmigen Fluidführung. Die Abzweigungen münden wiederum in Austrittskanalstränge **12** aus, die als Ableitungsleitung für gas- oder dampfförmige Fluide einen erweiterten Querschnitt aufweisen. Wie zuvor dargestellt, lassen sich die Austrittskanalstränge **12** wie die Austrittskanäle in **Fig.1a bis d** auch als Überhitzer konzipieren und einsetzen. Die dargestellten Ausführungen unterscheiden sich durch die Anzahl der Abzweigungspunkte in der ansonsten identischen Gestaltung der Mikrokanäle **3** und Einlaufstrecken **6**. **Fig.2b** zeigt eine doppelte Anzahl von bogenförmigen Fluidführungen **7** mit je einer fluidischen Abzweigung **8** als **Fig.2a**.

Zwischen zwei bogenförmige Fluidführungen mit Abzweigung ist jeweils mindestens eine abzweigungsfreie bogenförmige Fluidführung **13** (ohne Abzweigung) vorgesehen, in der wie in der Einlaufstrecke **6** eine gravimetrische Umordnung (Vorselektion) der flüssigen und dampfförmigen Fluidanteile im Fluidstrom stattfindet. Der anschließende geradlinige Mikrokanalabschnitt **14** dient der Homogenisierung der vorselektierten Phasen sowie der Strömung.

**Fig.2a** zeigt gegenüber **Fig.2b** eine verminderte Anzahl von bogenförmigen Fluidführungen **7** mit je einer fluidischen Abzweigung **8,** d.h. zwischen zwei Abzweigungen zusätzlich eine Kaskade von zwei direkt aufeinander folgenden bogenförmigen Fluidführungen in gegenläufiger Ausrichtung ohne Abzweigung. Diese Kaskade bewirkt eine zusätzliche Vorselektion wie eine zwischengeschaltete Einlaufstrecke in den Mikrokanälen. Diese zusätzliche Vortrennung und Gestaltung ist insbesondere bei der Trennung von zweiphasigen Fluidströmen mit geringen Dichteunterschieden vorteilhaft.

Durch drei in **Fig.2a und b** dargestellten Zuläufen **2** tritt ein flüssiges Fluid in die Verdampferstrukturen des Mikroverdampfers. Die Folienebene **4** wird vorzugsweise aus einem gasdichten, gegenüber dem Fluid korrosionsbeständigen und hinreichend wärmeleitfähigem Werkstoff (wie Edelstahl, Kupfer etc.) gefertigt. Die Wärmezufuhr erfolgt durch externe Wärmequellen wie z.B. durch benachbarte Folienebenen in die Verdampferstruktur (z.B. fluidisch über ein Temperierungsfluid in benachbarten Folienebenen, oder durch eine heiße Oberfläche wie z.B. zu kühlende Elektronik). Das Fluid fließt zunächst in die Einlaufstrecke **6,** d.h. durch die vorgenannten wechselseitig gekrümmten Fluidführungen und beginnt bereits hier zu verdampfen. Durch die Änderung der Krümmungsrichtung ändert sich nach jeder Kurve die Wirkungsrichtung der Zentrifugalkraft. Dampf und Flüssigkeit wechseln hier nach jeder Kurve die Seite. Im Mikrokanal **3** in der ersten bogenförmigen Fluidführung **7** mit fluidischer Abzweigung **8** kommt es zur ersten Trennung von dampfförmigen und flüssigen Fluidanteilen. Aufgrund der starken Volumenzunahme bei einer Verdampfung wird davon ausgegangen, dass hier mehr als 50% des Kanalquerschnitts des Mikrokanals **3** bereits mit Dampf gefüllt sind. Ein Teil des Dampfes reichert sich an der Innenseite der gekrümmten Fluidführung an und wird dort von der Abzweigung **8** aufgenommen. Der flüssige Anteil wird durch die Zentrifugalkraft nach außen gedrückt und verbleibt im Mikrokanal. Der abgetrennte Dampf hingehen wird durch die Austrittskanalstränge **12** zusammengeführt und in diesen aus der Verdampferstruktur transportiert.

Typischerweise weisen die in **Fig.2a und 2b** dargestellten Mikrokanäle **3** einen Kanalquerschnitt von typischerweise 0,1 bis 3 mm$^2$, die Austrittskanalstränge **12** einen bevorzugt mindestens doppelt so hohen Wert, z.B. von 0,2 bis 10 mm$^2$ auf.

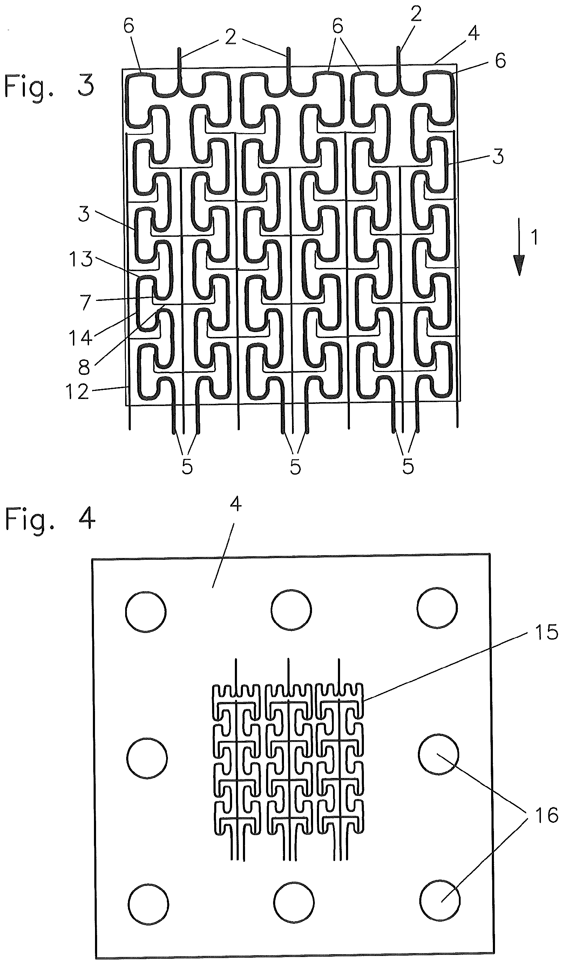

**Fig.3** zeigt ein entsprechendes Schema für einen Mikroverflüssiger/kondensator auf einer Folienebene **4**. Wie beim vorgenannten Verdampfer folgen den anfänglichen Einlaufstrecken **6** die Mikrokanäle **3** mit jeweils einem Austritt **5**. Die Einlaufstrecken **6** umfassen mindestens zwei aufeinander folgenden Kanalkrümmungen mit entgegengesetzter Krümmungsausrichtung. Die in Analogie zu der Ausführung in **Fig.2a** gestalteten Mikrokanäle **3** weisen bogenförmige Fluidführungen **7** mit Abzweigungen **8** und Austrittskanalstränge **12** sowie abzweigungsfreie bogenförmige Fluidführung **13** mit anschließenden geradlinigen Mikrokanalabschnitten **14** auf. Im Unterschied zu **Fig.2a** sind die Abzweigungen zur Ableitung von flüssigen Fluidanteilen außenseitig an den bogenförmigen Fluidführungen **7** angeordnet. Ferner sind die Ausstrittskanalstränge **12** in ihren Querschnitten für flüssige und die Mikrokanäle **3** für dampf- oder gasförmige Fluidanteile konzipiert. Folglich übersteigen im Gegensatz zu **Fig.2a und b** die Durchströmungsquerschnitte der Mikrokanäle vorzugsweise die der Austrittskanalstränge gem. **Fig.3**.

Anstelle flüssigen Mediums tritt bei einer Verflüssigungsstruktur Gas oder Dampf in die Mikrokanäle ein. Die Wärmeabfuhr erfolgt durch externen Wärmesenken wie z.B. durch benachbarte Folienebenen, z.B. fluidisch über ein Temperierungsfluid in benachbarten Folienebenen, oder durch eine kalte Oberfläche z.B. einer Luftkühlung mit Kühlrippen. Das zu kondensierende gas- oder dampfförmige Fluid fließt zunächst durch wechselseitig gekrümmte Bahnen der Einlaufstrecke **6** und beginnt bereits hier zu kondensieren. Dabei kommt es zu einer ersten stofflichen Trennung von flüssigen und gas- bzw. dampfförmigen Fluidanteilen im Fluidstrom. Es folgt ein Eintritt in die Mikrokanäle **3** und in die bogenförmige Fluidführungen **7,** wobei ein Teil der kondensierten Fluidanteile an der Außenseite des gekrümmten Fluidführung über Abzweigungen **8** abgeleitet wird, während der Dampfanteil durch die Zentrifugalkraft nach innen gedrückt wird und weiterhin den weiteren Verlauf des Mikrokanals **3** zum Austritt **5** folgt.

Der abgetrennte flüssige Anteil hingehen wird in Austrittskanalsträngen **12** gesammelt und in diesen aus der Verflüssigungsstruktur transportiert. Wie in **Fig.1e bis g** für die Austrittskanäle **10** dargestellt, lassen sich die Ausstrittskanalstränge **12** bei einem Mikroverfüssiger als Unterkühler konzipieren und einsetzen. Die Abtrennung von flüssigen Fluidanteilen wiederholt sich iterativ in mehreren hintereinander angeordneten bogenförmigen Fluidführungen **7** mit fluidischen Abzweigungen **8**.

**Fig.4** zeigt beispielhaft ein Layout einer Folie aus einem nichtrostenden Chrom-Nickel-Stahl mit einer ebenen Mikroverdampferstruktur auf einer Folienseite für einen Einsatz in einem Wärmetauscher in Schichtbauweise. Die beispielhaften lateralen Abmessungen betragen 120 x 120mm für die Folie und 65 x 65 mm für die Struktur, die zu einem späteren Zeitpunkt aus der Folie herausgearbeitet und im Mikrowärmetauscher integriert wird. Die Folienstärke beträgt beispielhaft 0,5 mm. Die Kanalstrukturen **15** werden durch bekannte Mikrostrukturierungsverfahren wie z.B. Mikrofräsen, Erodieren oder chemische Ätzverfahren eingebracht. Hierzu weist die Folie beispielhaft Mittel zur Zentrierung wie z.B. Führungsbohrungen **16** auf. Die Kanaltiefe ist vorzugsweise einheitlich und beträgt im Beispiel zwischen 0,1 und 0,4, vorzugsweise zwischen 0,2 und 0,3 mm. Die Struktur gilt mit dieser bevorzugten aber nicht zwingend erforderlichen einheitlichen Tiefe auch fertigungstechnisch als 2D-Struktur (2D entspricht eine einheitliche Kanaltiefe). Das Design der dargestellten Mikroverdampferstruktur entspricht dem in Fig.2a wiedergegebenen. Die Kanalbreiten der Einlaufstrecke, der Mikrokanäle und der Abzweigungen betragen vorzugsweise zwischen 0,1 und 1,5 mm, im Beispiel 1 mm, die der Austrittskanalstrangs vorzugsweise 1,5 bis 4 mal diesem vorgenannten Wert, im Beispiel 2 mm.

In der in **Fig.4** dargestellten Struktur wurde erfolgreich Kältemittel R134a verdampft. Hierbei konnte ein Wasserfluidstrom von 110 ml/min von 50°C auf 8°C gekühlt werden. Die anhand von Messwerten bestimmte übertragene Kühlleistung betrug dabei ca. 317 W, wobei unter Berücksichtigung der theoretischen Verdampfungsenthalpie des Kältemittels von einer nahezu vollständigen Verdampfung innerhalb der Mikroverdampferstruktur ausgegangen werden kann. Vergleichsversuche mit einer konventionellen Verdampferstruktur mit gleichen Abmessungen, wie z.B. in **[1]** offenbart, zeigen bei identischen Randbedingungen einen eine Durchsatzsteigerung um 120%.

Eine weitere nicht explizit dargestellte Ausführung der Verdampferstruktur sieht vor, eine Stufenstruktur, vorzugsweise eine Stufe an, vorzugsweise unmittelbar hinter der Abzweigung vorzusehen. Diese Stufe dient insbesondere der Abbremsung und Umlenkung von Gasbestandteilen wie Gasblasen über bzw. in die Abzweigung. Weiter bevorzugt umfasst die Stufe eine Prallfläche für Gasblasen, die in die Strömung hineinragt und an der die Gasblasen auftreffen, abgebremst und letztendlich in die Abzweigung abgeleitet werden.

**Literatur:**

[1] Wibel W., Schygulla U., Brandner J.: Micro device for liquid cooling by evaporation of R134a, Chemical Engineering Journal, In Press, CEJ 2011
[2] DE 101 32 370 B4
[3] DE 10 2009 039 397 A1
[4] DE 10 2008 006 513 A1

**Bezugszeichenliste:**

| | |
|---|---|
| 1 | Fließrichtung |
| 2 | Zulauf |
| 3 | Mikrokanal |
| 4 | Folienebene |
| 5 | Austritt |
| 6 | Einlaufstrecke |
| 7 | bogenförmige Fluidführung |
| 8 | fluidische Abzweigung |
| 9 | Wärmeübertragungstrecke |
| 10 | Austrittskanal |
| 11 | gasdurchlässige Membran |
| 12 | Austrittskanalstrang |
| 13 | abzweigungsfreie bogenförmige Fluidführung |
| 14 | geradliniger Mikrokanalabschnitt |
| 15 | Kanalstruktur |
| 16 | Führungsbohrung |

**Patentansprüche**

**1.** Wärmetauscherstruktur mit einer Wärmetauscherstrecke für eine Temperierung eines Fluidstrom, umfassend mindestens einen Mikrokanal **(3)** mit mindestens einer bogenförmiger Fluidführung **(7)** nach zumindest einem Teil der Wärmetauschstrecke mit mindestens einer fluidischen Abzweigung **(8)** für eine phasenreine Abzweigung einer durch die Temperierung in der Wärmetauschstrecke umgewandelten Phase des Fluidstroms an und/oder hinter der bogenförmigen Fluidführung, wobei alle der mindestens einen Abzweigung in mindestens einen Austrittskanal **(10)** aus der Wärmetauscherstruktur ausmündet,
**dadurch gekennzeichnet, dass**

a) die Mikrokanäle mindestens eine Einlaufstrecke **(6)** mit mindestens zwei aufeinander folgenden Kanalkrümmung mit entgegengesetzter Krümmungsausrichtung aufweisen,
b) mindestens eine bogenförmige Fluidführung **(7)** mit einer fluidischen Abzweigung **(8)** sich unmittelbar an die Einlaufstrecke **(6)** anschließt sowie
c) je Mikrokanal **(3)** mindestens zwei bogenförmigen Fluidführungen **(7)** jeweils mit Abzweigungen **(8)** vorgesehen sind, zwischen denen mindestens eine Kaskade aus einer abzweigungsfreien bogenförmigen Fluidführung **(13)** und einem an diese anschließenden geradlinigen Mikrokanalabschnitt **(14)** angeordnet ist.

**2.** Wärmetauscherstruktur nach Anspruch 1, **dadurch gekennzeichnet, dass** die Wärmetauscherstrecke durch eine ebene Kanalstruktur gebildet ist.

3. Verflüssigungsstruktur mit einer Wärmetauscherstruktur nach Anspruch 1 oder 2, **dadurch gekennzeichnet, dass** mindestens eine Abzweigung **(8)** an der Außenseite einer bogenförmigen Fluidführung **(7)** angeordnet ist.

4. Verflüssigungsstruktur nach Anspruch 3, **dadurch gekennzeichnet, dass** die Abzweigung oder eine Blende in der Abzweigung einen kleineren Durchflussquerschnitt als der Mikrokanal aufweist.

5. Verdampfungsstruktur mit einer Wärmetauscherstruktur nach Anspruch 1 oder 2, **dadurch gekennzeichnet, dass** mindestens eine Abzweigung **(8)** an der Innenseite einer bogenförmigen Fluidführung **(7)** angeordnet ist.

6. Verdampfungsstruktur nach Anspruch 5, **dadurch gekennzeichnet, dass** die Abzweigung einen größeren Durchflussquerschnitt als der Mikrokanal aufweist.

7. Verdampfungsstruktur nach Anspruch 5 oder 6, **dadurch gekennzeichnet, dass** die Abzweigung eine gasdurchlässige Membran **(11)** oder Filterelement aufweist.

8. Verdampfungsstruktur nach einem der Ansprüche 5 bis 7, **dadurch gekennzeichnet, dass** die Abzweigung mindestens eine Stufenstruktur zur Gasblasenumlenkung in die Abzweigung aufweist.

9. Verdampfungsstruktur nach Anspruch 8, **dadurch gekennzeichnet, dass** die Stufenstruktur eine Prallfläche für Gasblasen aufweist.


**Claims**

1. Heat exchanger structure with a heat exchanger segment for the temperature changing of a fluid flow, comprising at least one microchannel **(3)** with at least one bow-shaped fluid conveying section **(7)** following at least one part of the heat exchange segment with at least one fluidic branching **(8)** for a pure-phase branching of a phase of the fluid flow, converted by the temperature change in the heat exchange segment, at and/or behind the bow-shaped fluid conveying section, wherein everything from the at least one branching opens into at least one outlet channel **(10)** out of the heat exchanger structure, **characterised in that**

   a) the microchannels comprise at least one inlet segment **(6)** with at least two channel bends following one another with counter-directional bend alignment,
   b) at least one bow-shaped fluid conveying section **(7)** with a fluidic branching **(8)** connecting directly to the inlet segment **(6)**, and
   c) for each microchannel **(3)**, at least two bow-shaped fluid conveying sections **(7)**, in each case with branchings **(8)**, arranged between which is at least one cascade of a branching-free bow-shaped fluid conveying section **(13)** and of a straight microchannel section **(14)** connecting to this.

2. Heat exchanger structure according to claim 1, **characterised in that** the heat exchanger segment is formed by a flat channel structure.

3. Evaporation structure with a heat exchanger structure according to claim 1 or 2, **characterised in that** at least one branching **(8)** is arranged on the outside of a bow-shaped fluid conveying section **(7).**

4. Evaporation structure according to claim 3, **characterised in that** the branching, or a diaphragm or aperture in the branching, exhibits a smaller throughflow cross-section than the microchannel.

5. Evaporation structure with a heat exchanger structure according to claim 1 or 2, **characterised in that** at least one branching **(8)** is arranged on the inner side of a bow-shaped fluid conveying section **(7).**

6. Evaporation structure according to claim 5, **characterised in that** the branching exhibits a larger throughflow cross-section than the microchannel.

7. Evaporation structure according to claim 5 or 6, **characterised in that** the branching comprises a gas-permeable membrane **(11)** or filter element.

8. Evaporation structure according to any one of claims 5 to 7, **characterised in that** the branching comprises at least one step structure for gas bubble deflection into the branching.

9. Evaporation structure according to claim 8, **characterised in that** the step structure comprises an impact surface for gas bubbles.


**Revendications**

1. Structure d'échangeur de chaleur comportant un chemin d'échange de chaleur pour mettre en température une veine de fluide, comportant au moins un micro-canal (3) avec au moins un guide de fluide (7), coudé après au moins une partie du chemin d'échange de chaleur avec au moins une dérivation fluidique (8) pour une dérivation en phase pure d'une phase de la veine de fluide convertie par la mise en température dans le chemin d'échange de chaleur sur et/ou en aval du guide de fluide coudé, toutes les dérivations débouchant dans au moins un canal de sortie (10) pour quitter la structure d'échangeur de chaleur, structure **caractérisée en ce que**

a) les micro-canaux ont au moins un chemin d'entrée (6) avec au moins deux coudes de canal qui se suivent avec des directions de courbure opposées,
b) au moins un guide de fluide (7) coudé avec une dérivation fluidique (8) faisant directement suite au chemin d'entrée (6) ainsi que,
c) pour chaque micro-canal (3) au moins deux guides de fluide (7) coudés avec chaque fois des dérivations (8) entre lesquelles il y a au moins une cascade formée d'un guide de fluide coudé (13) sans dérivation et d'un segment de micro-canal (14), droit, directement adjacent.

2. Structure d'échangeur de chaleur selon la revendication 1,
**caractérisée en ce que**
le chemin d'échange de chaleur est formé par une structure de canal, plane.

3. Structure de liquéfaction avec une structure d'échangeur de chaleur selon la revendication 1 ou 2,
**caractérisée en ce que**
le côté de sortie d'un guide de fluide (7) coudé comporte au moins une dérivation (8).

4. Structure de liquéfaction selon la revendication 3,
**caractérisée en ce que**
la dérivation ou un diaphragme de la dérivation ont une section de passage plus petite que celle du micro-canal.

5. Structure de vaporisation comportant une structure d'échangeur de chaleur selon la revendication 1 ou 2,
**caractérisée en ce que**
le côté antérieur d'un guide de fluide coudé (7) comporte au moins une dérivation (8).

6. Structure d'évaporation selon la revendication 5,
**caractérisée en ce que**
la dérivation a une section de passage plus grande que celle du micro-canal.

7. Structure d'évaporation selon la revendication 5 ou 6,
**caractérisée en ce que**
la dérivation a une membrane (11) perméable aux gaz ou un élément de filtre.

8. Structure d'évaporation selon l'une des revendications 5 à 7,

**caractérisée en ce que**
la dérivation a au moins une structure étagée pour accumuler les bulles de gaz dans la dérivation.

9. Structure d'évaporation selon la revendication 8,
**caractérisée en ce que**
la structure étagée comporte une surface brise-jet pour les bulles de gaz.

Fig. 1a

Fig. 1b

Fig. 1c

Fig. 1d

Fig. 1e

Fig. 1f

Fig. 1g

Fig. 2a

Fig. 2b

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10132370 B4
- DE 102009039397 A1
- DE 102008006513 A1

**In der Beschreibung aufgeführte Nicht-Patentliteratur**

- Micro device for liquid cooling by evaporation of R134a. **WIBEL W. ; SCHYGULLA U. ; BRANDNER J.** Chemical Engineering Journal. In Press, CEJ, 2011